# EUROPÄISCHE PATENTANMELDUNG

(11) **EP 0 856 940 A1**
(43) Veröffentlichungstag der Anmeldung: **05.08.1998**
(21) Anmeldenummer: 97115399.4
(22) Anmeldetag: 05.09.1997
(51) Int. Cl.: H03D 7/14, H03C 1/54

(54) **Diodenanordnung für einen Doppelgegentaktmischer**

(30) Priorität: 31.01.1997 DE 19703687
(71) Anmelder: ROBERT BOSCH GMBH, 70442 Stuttgart (DE)
(72) Erfinder: Bischof, Werner, 71522 Backnang (DE)

(57) **Zusammenfassung**

Eine sehr platzsparende und geringe Leitungslängen erfordernde Diodenanordnung weist vier Dioden (D1, D2, D3, D4) auf, die über Verbindungsleitungen (V1, V2, V3, V4) in Form einer 8 zusammengeschaltet sind. Dabei überkreuzen sich zwei der Verbindungsleitungen (V3, V4) innerhalb einer von den Dioden (D1, D2, D3, D4) augespannten Fläche.

## Beschreibung

### Stand der Technik

Die vorliegende Erfindung betrifft eine Diodenanordnung für einen Doppelgegentaktmischer mit vier zu einem Ring zusammengeschalteten Dioden, wobei vier Verbindungsleitungen die Dioden in Form einer 8 zusammenschalten.

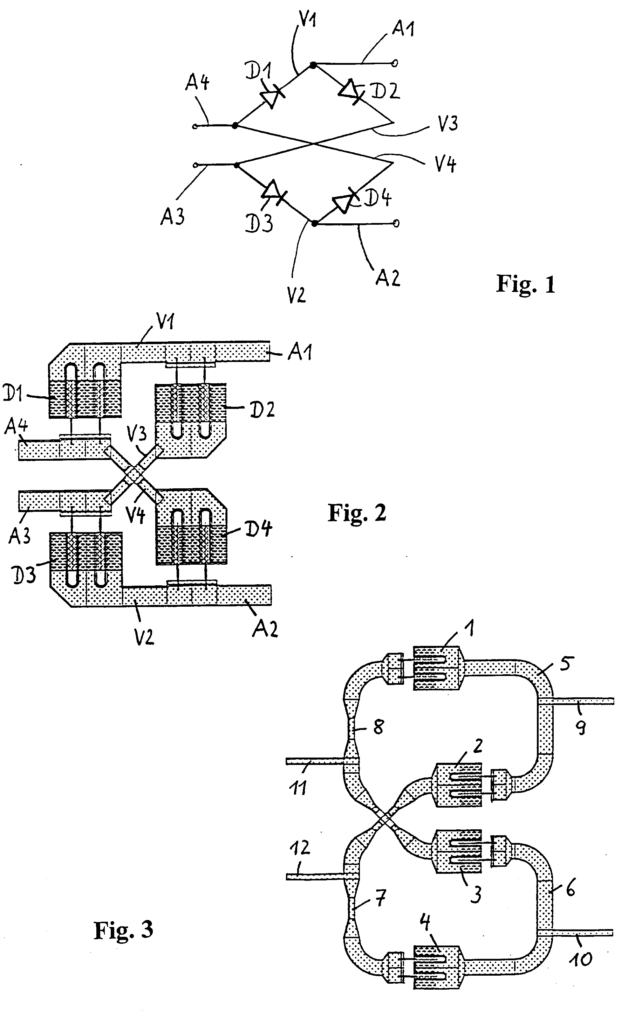

Eine solche in Figur 3 dargestellte Diodenanordnung ist bekannt aus einer Veröffentlichung von W. Brinlee, K. Varian, A. Pavio, 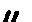 A Novel Planar Double-Balanced 6-8 GHz MMIC Mixer", IEEE MTT-Symposium Digest, 1994, Session TV1A-2.

Wie dem in der Figur 3 dargestellten Layout der bekannten MMIC-Schaltung (Monolithic Microwave Integrated Circuit) zu entnehmen ist, sind die vier Dioden 1, 2, 3 und 4 nebeneinander angeordnet, und die Verbindungsleitungen 5, 6, 7 und 8 zwischen ihnen verlaufen in Form einer unsymmetrischen 8. Bei dieser Diodenanordnung läßt es sich nicht vermeiden, daß die beiden einander überkreuzenden Verbindungsleitungen 7 und 8 eine relativ große Länge haben. Mit jeder der Verbindungsleitungen 5, 6, 7 und 8 ist eine Anschlußleitung 9, 10, 11, 12 kontaktiert. Zur Ankopplung eines Lokaloszillatorsignals, eines Hochfrequenzeingangssignals und eines Mischerausgangssignals. Die gemäß dem Stand der Technik ausgeführte Diodenanordnung benötigt relativ viel Platz und lange Verbindungsleitungen, was den Betriebsfrequenzbereich des Doppelgegentaktmischers einschränkt.

Der Erfindung liegt daher die Aufgabe zugrunde, eine Diodenanordnung der eingangs genannten Art anzugeben, die sehr flächensparend aufgebaut ist und mit möglichst kurzen Längen der Verbindungsleitungen auskommt.

### Vorteile der Erfindung

Die genannte Aufgabe wird mit den Merkmalen des Anspruchs 1 dadurch gelöst, daß zwei der Verbindungsleitungen sich innerhalb einer von den Dioden aufgespannten Fläche überkreuzen. Dadurch können die Dioden sehr eng zusammenrücken und die Verbindungsleitungen zwischen ihnen werden extrem kurz. Durch die kurzen Leitungslängen wird der Frequenzbereich des Doppelgegentaktmischers erweitert.

Sorgt man gemäß dem Unteranspruch dafür, daß die Verbindungs- und Anschlußleitungen eine symmetrische Leitungskonfiguration bilden, läßt sich die Lokaloszillatorfrequenz am Mischerausgang besser unterdrücken.

### Beschreibung eines Ausführungsbeispiels

Anhand eines in der Zeichnung dargestellten Ausführungsbeispiels wird nachfolgend die Erfindung näher erläutert. Es zeigen:
Figur 1 ein Prinzipschaltbild einer 8-förmigen Diodenanordnung,
Figur 2 ein Layout für eine MMIC-Schaltung der 8-förmigen Diodenanordnung und
Figur 3 ein Layout einer Diodenandordnung gemäß dem Stand der Technik.

Der in der Figur 1 dargestellte Diodenring für einen Doppelgegentaktmischer besteht aus vier Dioden D1, D2, D3 und D4, welche über Verbindungsleitungen V1, V2, V3 und V4 zu einem Ring zusammengeschaltet sind. Die Dioden D1, D2, D3 und D4 sind so angeordnet, daß sie eine viereckige Fläche - vorzugsweise eine rechteckige Fläche - zwischen sich aufspannen. Die Verbindungsleitung V3 von der Diode D2 zur Diode D3 und die Verbindungsleitung V4 von der Diode D4 zur Diode D1 verlaufen durch die zwischen den Dioden aufgespannte Fläche und überkreuzen sich darin. Somit erhält der Diodenring die Form einer symmetrischen 8. Mit diesem Verlauf der Verbindungsleitungen V1, V2, V3 und V4 kommt man mit extrem kurzen Leitungslängen aus, was sich günstig auf die Bandbreite der Betriebsfrequenz des Doppelgegentaktmischers auswirkt.

Zur Ankopplung eines Lokaloszillatorsignals, eines Hochfrequenzeingangssignals und eines Mischerausgangssignals an den Diodenring, sind Anschlußleitungen A1, A2, A3 und A4 mit den einzelnen Verbindungsleitungen V1, V2, V3 und V4 kontaktiert. An diese Anschlüsse A1, A2, A3, A4 werden in bekannter Weise Symmetrierglieder angeschaltet, die eine symmetrische Zuführung der genannten Signale an den Diodenring ermöglichen. Die Anschaltung der Signale über die Symmetrierglieder wird hier nicht näher ausgeführt, da sie dem Stand der Technik entspricht und nicht Gegenstand der vorliegenden Erfindung ist.

Der 8-förmige Diodenring läßt es zu, daß die mit den sich gegenseitig überkreuzenden Verbindungsleitungen V3 und V4 kontaktierten Anschlußleitungen A3 und A4 gleich lang sind. Ebenso können die mit den Verbindungsleitungen V1 und V2 kontaktierten Anschlußleitungen A1 und A2 gleich lang ausgeführt sein. Dadurch ergibt sich eine völlig symmetrische Leitungskonfiguration, welche für eine optimale Unterdrückung der Lokaloszillatorfrequenz im Mischerausgangssignal sorgt.

Das in der Figur 2 dargestellte Layout einer MMIC-Schaltung macht den vorteilhaft symmetrischen Aufbau des Doppelgegentaktmischers sehr deutlich. In dem Layout sind die den Schaltungsteilen in Figur 1 entsprechenden Bereiche mit denselben Bezugszeichen versehen worden.

Das in der Figur 3 dargestellte Layout einer MMIC-Schaltung ist bereits in der Beschreibungseinleitung als Stand der Technik beschrieben worden.

## Patentansprüche

1. Diodenanordnung für einen Doppelgegentaktmischer mit vier zu einem Ring zusammengeschalteten Dioden (D1, D2, D3, D4), wobei die vier Verbindungsleitungen (V1, V2, V3, V4) die Dioden (D1, D2, D3, D4) in Form einer 8 zusammenschalten, dadurch gekennzeichnet, daß zwei der Verbindungsleitungen (V3, V4) sich innerhalb einer von den Dioden (D1, D2, D3, D4) aufgespannten Fläche überkreuzen.

2. Diodenanordnung nach Anspruch 1, dadurch gekennzeichnet, daß jede Verbindungsleitung (V1, V2, V3, V4) mit einer Anschlußleitung kontaktiert ist zur Ankopplung eines Lokaloszillatorsignals, eines Hochfrequenzeingangssignals und eines Mischerausgangssignals, wobei die Verbindungs- (V1, V2, V3, V4) und Anschlußleitungen (A1, A2, A3, A4) so verlaufen, daß eine symmetrische Leitungskonfiguration entsteht.
